(19) Europäisches Patentamt

European Patent Office

Office européen des brevets

(11) **EP 1 094 504 A2**

(12) **EUROPEAN PATENT APPLICATION**

(43) Date of publication:
25.04.2001 Bulletin 2001/17

(51) Int. Cl.[7]: **H01L 21/285**, C23C 14/00

(21) Application number: 00309118.8

(22) Date of filing: 17.10.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **18.10.1999 US 159986 P**

(71) Applicant:
**Applied Materials, Inc.**
**Santa Clara, California 95054 (US)**

(72) Inventors:
• **Sun, Bingxi**
**Sunnyvale, Ca 94086 (US)**
• **Ding, Peijun**
**San Jose, Ca 95129 (US)**
• **Chin, Barry**
**Saratoga, Ca 95070 (US)**
• **Maity, Nirmalya**
**San Jose, Ca 95117 (US)**
• **Banthia, Vikash**
**Santa Clara, Ca 95051 (US)**

• **Herner, Brad S.**
**San Francisco, Ca 94103 (US)**
• **Saigal, Dinesh**
**San Jose, Ca 95135 (US)**
• **Chang, Bertha P.**
**San Jose, Ca 95131 (US)**
• **Kitabjian, Paul**
**Mountain View, Ca 94040 (US)**
• **Mak, Alfred**
**Union City, Ca 94587 (US)**
• **Yao, Gonda**
**Fremont, Ca 94539 (US)**
• **Xu, Zheng**
**Foster City, Ca 94404 (US)**

(74) Representative:
**Bayliss, Geoffrey Cyril et al**
**BOULT WADE TENNANT,**
**Verulam Gardens**
**70 Gray's Inn Road**
**London WC1X 8BT (GB)**

(54) **PVD-IMP tungsten and tungsten nitride as a liner, barrier, and/or seed layer**

(57) The disclosure relates to a method of depositing a tungsten-based liner/barrier layer on a substrate (40), preferably using a high-density plasma PVD process, such as an ionized metal plasma (IMP) process or other processes with ionize a sputtered flux of material from a target. If a Ti and/or TiN liner/barrier layer (54) is deposited, the method reduces or eliminates the reactions between $WF_6$ and the Ti, TiN, and Si materials by depositing tungsten by PVD-IMP processing thereover. Tungsten may also be deposited in the presence of a nitrogen source to produce a tungsten nitride liner/barrier layer (52). The tungsten liner/barrier layer may be followed by another tungsten layer deposited by a CVD process. The tungsten and other materials can also be deposited by other processes such as electroplating processes and other types of PVD including non-ionized sputtering, collimated sputtering, and long throw sputtering.

Fig. 2A

EP 1 094 504 A2

**Description**

The present invention relates to an apparatus and method for depositing tungsten layers on substrates. Specifically, the invention relates to a method and apparatus for depositing tungsten-containing materials as a liner, barrier, and/or seed layer.

Sub-quarter micron multilevel metallization represents one of the key technologies for the next generation of ultra large scale integration (ULSI) for integrated circuits (IC). Reliable formation of multilevel interconnect features, including contacts, vias, lines, and trenches is very important to the success of ULSI and to the continued effort to increase circuit density on individual substrates and die. As circuit densities increase, the widths of vias, contacts and other features decrease to 0.25 μm or less, whereas the thicknesses of the dielectric layers remains substantially constant, thereby increasing the aspect ratios for the features, *i.e.,* their height divided by width. Many traditional deposition processes have difficulty filling structures where the aspect ratio exceeds 3:1, and particularly where the aspect ratio approaches 10:1.

Traditionally aluminum has been used to form conductive features of IC's, such as lines, trenches and vias in semiconductor processing. Copper is now being accepted as a conductive material to be used in IC's because of a lower resistivity. However, copper presents its own difficulties in processing. For instance, copper readily diffuses into adjacent layers absent a barrier layer. Copper also readily oxidizes when exposed to ambient conditions, thereby increasing the resistance of the copper feature and reducing the reliability of the overall circuit. Tungsten provides an alternative to aluminum and copper for vias, plugs, contacts, lines, trenches and other features. Tungsten has conventionally been used as a conductor at the first level of metal interconnects (M1 level). Although tungsten has a higher electrical resistivity (10 μΩ-cm) than aluminum and copper (3.1 μΩ-cm and 1.7 μΩ-cm, respectively), tungsten demonstrates fine-line patternability, suitable for the smaller features of the ULSI circuitry. Fine-line patternability refers to the characteristic of a material to be patterned and etched consistently and with straight sidewalls. Tungsten also provides excellent step coverage within features.

However, each metallization scheme typically requires a liner layer and/or a barrier layer to be deposited in a feature formed within the dielectric material before depositing the aluminum, copper or tungsten conductor. The liner layer provides good adhesion to the underlying material and the barrier layer prevents diffusion of the metal into adjacent materials. Additionally, the barrier layer prevents unwanted reactions between underlying materials. Liner and/or barrier layers are typically made of materials such as titanium (Ti), titanium nitride (TiN), tantalum (Ta), tantalum nitride (TaN) and other refractory metals and their nitrated counterparts. A thin layer of the liner/barrier layer material is preferably deposited conformally over the surface of the substrate including within a feature on both the sidewalls and the bottom of the feature. One problem with conventional liner and barrier layers is that they have a higher resistance than the metal which forms the feature. As a result, the overall resistance of the feature is increased. For example, Ti has a resistance of about 40 μΩ-cm and TiN has a resistance of about 300 μΩ-cm to about 400 μΩ-cm. Ta has a typical resistance of about 160 μΩ-cm and TaN has a typical resistance of about 240 μΩ-cm. Thus, the barrier/liner materials exhibit a resistance of which is at least about five times that of conventional conductive materials.

Additionally, tungsten is typically deposited on a substrate using a chemical vapor deposition (CVD) process. The typical CVD process uses hydrogen and tungsten hexafluoride ($WF_6$) as reactive gases for depositing tungsten, known as a hydrogen reduction process. The reaction of hydrogen with $WF_6$ causes deposition of tungsten on the substrate 2, yields good step coverage, and is believed to have remaining byproducts of fluorine gases and hydrofluoric acid (HF). However, the hydrogen reduction process is relatively slow without an initial seed layer of tungsten, and therefore another reduction process using silane with $WF_6$ is used to deposit an initial seed layer. The silane reduction process for depositing tungsten using a CVD process reacts silane with $WF_6$ and yields tungsten and other byproducts. Some evidence suggests the byproducts could be $SiHF_3$, HF, and/or $SiF_4$. The silane reduction process provides a higher initial deposition rate than the hydrogen reduction reaction. Hydrogen reduction deposition is typically faster once the seed layer has been established. Therefore, CVD of tungsten typically is carried out as a two-step process wherein silane reduction is used to deposit a tungsten seed layer and then the hydrogen reduction process is used to complete the deposition.

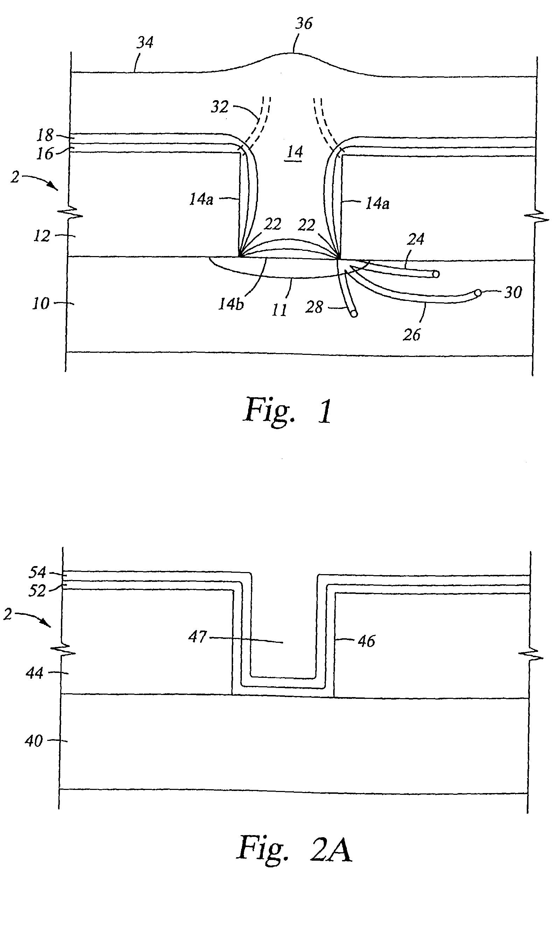

Figure 1 is a schematic view of a structure 2 formed on a substrate depicting challenges associated with CVD of tungsten. The substrate 2 includes the underlying wafer 10, doped region 11 and patterned dielectric layer 12. A liner layer 16 of Ti is deposited over the dielectric layer 12 typically by a physical vapor deposition (PVD) followed by a barrier layer 18 of TiN. The TiN barrier layer 18 also acts as a wetting layer for a subsequent deposition such as aluminum or aluminum alloys. The Ti layer is used as a liner layer and the TiN is used as a barrier layer to protect the underlying Ti and Si in the silicon oxide dielectric material. As aspect ratios of features increase, it is becoming more difficult to ensure conformal coverage of the sidewalls and bottom of a feature 14, especially at the lower corners 22 between the sidewalls 14a and the bottom 14b. As a result, those areas are susceptible to chemical attack by the CVD W precursor gases used, such as $WF_6$ or byproducts.

$WF_6$ and/or byproducts that can diffuse through the TiN layer and react with the underlying Ti layer 16 and form defects in the various layers, known in the field as "wormholes" and "volcanoes". Wormholes 24, 26, and 28 are tunnels formed by the encroachment and tunneling under an oxide layer in the wafer 10, which can extend several tenths of a micron. Wormholes, such as wormhole 26, are typically void of material except for a tungsten particle 30 deposited at their ends.

The $WF_6$ and/or byproducts can also diffuse through the TiN layer 18 to react with the Ti in the underlying Ti layer 16 and form a volcano 32. The reaction reduces adhesion between Tin layer 18 and Ti layer 16 in the area where the reaction of Ti and $WF_6$ occurs. The TiN layer 18 delaminates as a result of a growth of tungsten between the Ti and TiN layers or by the production of $TiF_4$ gas or $TiF_3$ as a low density solid, thus forming the volcano 32. When the conductor layer 34 of tungsten is deposited on the TiN surface 18, a "mound" 36 forms over the volcano 32. The mound 36 adversely affects surface planarization, can cause short circuits in the metallization layer of the IC, and, thus, is unacceptable for multilevel metallization of ULSI circuitry.

Efforts in the field have focused on processing techniques to enhance the effectiveness of TiN as a liner/barrier in tungsten deposition to avoid the reaction of tungsten with Ti and to produce a reliable structure using tungsten. Some efforts have studied an increased TiN layer thickness. However, simply increasing the TiN layer thickness is not a solution. As explained in at least one article, "TiN Barrier Integrity And Volcano Formation In W-Plug Applications", S. Parikh, et al, *Thin Solid Films* 320, p. 26-30, Elsevier Science S.A. (1998), incorporated herein by reference, a thicker layer of TiN reduces the number of volcano occurrences, but increases the circuit resistance and produces larger volcanoes when the volcanoes do occur. Another article, "Failure of Titanium Nitride Diffusion Barriers During Tungsten Chemical Vapor Deposition: Theory and Practice", M. Rutten, et al., *Conference Proceedings ULSI-VII, Materials Research Society* (1992), also incorporated herein by reference, notes similar challenges and states that reactive sputtering of TiN can eliminate the barrier attack, but yield an undesirably high resistance for contacts and vias. The article suggests creating a "bi-layer" deposition of Ti, followed by the introduction of nitrogen with Ti to produce a TiN layer over the Ti layer, followed by annealing with nitrogen to "stuff" any exposed Ti and promote better resistance to $WF_6$ attack. Another article, entitled "Integrated Barrier/Plug Fill Schemes for High Aspect Ratio Gb DRAM Contact Metallization", Yu-Pei Chen, et al, *Thin Solid Films* 320, p. 73-76, Elsevier Science S.A. (1998), incorporated herein by reference, concludes that for tungsten plug contacts, a CVD Ti liner layer with a PECVD (plasma enhanced CVD) TiN barrier layer, and an IMP Ti liner layer with an ECVD (plasma enhanced metal organic CVD) TiN barrier layer show better contact integrity compared to a collimated PVD Ti liner layer with an ECVD TiN barrier layer for 0.3 um, 5:1 aspect ratio contacts. The above articles demonstrate that prior efforts emphasize improving the effectiveness of Ti and/or TiN. Other efforts have sought to use TiW as a barrier layer, but the step coverage around the features is generally less than adequate for ULSI circuitry.

There remains a need for an improved liner, barrier, and/or seed layer that reduces the attack of subsequent precursor reactants and promotes better conformal coverage of subsequent layers.

The present invention provides a method of depositing a tungsten-containing material as a liner/barrier layer on a substrate, preferably using a high-density plasma PVD process, typically referred to as an ionized metal plasma (IMP) process. Optionally, if a Ti and/or TiN liner/barrier layer is deposited, the present invention provides a method of reducing or eliminating the reactions between $WF_6$ and the Ti, TiN, and Si materials by depositing tungsten using a PVD-IMP process to obtain an initial seed layer. Tungsten may also be deposited in the presence of a nitrogen source to produce a tungsten nitride liner/barrier layer. The tungsten liner/barrier layer may be followed by another tungsten layer deposited by a CVD process. Additionally, other conductive materials, such as aluminum and copper, can be deposited on one or more of the tungsten layers. The tungsten and other materials can be deposited by other processes such as other types of PVD processes including conventional sputtering, collimated sputtering, and long throw sputtering.

In one aspect, the invention provides a method of depositing tungsten on a substrate, comprising sputtering tungsten from a target, passing at least a portion of the sputtered tungsten through an electromagnetic field disposed between the target and a substrate, and attracting the tungsten to the substrate to form a first tungsten layer. In another aspect, the invention provides a substrate, comprising a first tungsten layer deposited on the substrate by an ionized metal plasma process or other PVD processes that can provide good step coverage of high aspect features, followed by deposition of aluminum, copper or tungsten or combinations thereof. In another aspect, the invention provides a method of depositing tungsten on a substrate, comprising biasing the substrate, depositing a first tungsten layer, and altering the film stress level of the multilevel substrate with the first tungsten layer. In another aspect, the invention provides a method of depositing a tungsten layer on a substrate, comprising sputtering tungsten from a target, exposing the tungsten to nitrogen, and attracting the tungsten and nitrogen to a substrate to form a tungsten nitride layer. In another aspect, the invention provides a substrate comprising a barrier layer of sputtered tungsten nitride on a substrate. In another aspect, the invention provides a method of depositing tungsten on a substrate, comprising sputtering tungsten from a target to form a first tungsten layer and depositing a second tungsten layer by a CVD process on the first tungsten layer. In another aspect, the present invention provides a substrate processing system comprising a sputtering chamber having a tungsten target disposed in the chamber connected to a first power supply and a substrate support disposed in the chamber, a coil disposed between the target and the substrate support connected to a second power supply, and a controller that controls a first power output from the first power supply to sputter material from the tungsten target.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figure 1 is a schematic view of a substrate, illustrating challenges associated with the typical deposition of Ti, TiN, and tungsten layers.

Figure 2 is a schematic cross-sectional view of an IMP chamber.

Figure 2A is a schematic cross-sectional view of a structure of the invention.

Figure 2B is a schematic cross-sectional view of a structure of the invention.

Figure 2C is a schematic cross-sectional view of a structure of the invention.

Figure 3 is a schematic partial perspective view of an integrated processing system.

Figure 3A is a schematic cross-sectional view of a CVD chamber.

Figure 4 is a graph of the sheet resistance uniformity relative to different process parameters.

Figure 5 is a graph of stress and $R_s$ uniformity relative to different process parameters.

Figure 6 is a graph of the film resistivity relative to the film thickness with and without a substrate bias.

Figure 7 is a representation of the IMP tungsten grain size without a substrate bias.

Figure 8 is a representation of the IMP tungsten grain size with a 350 watt substrate bias and a 50% duty cycle.

Figure 9 is a representation of the IMP tungsten grain size with a 500 watt substrate bias and a 50% duty cycle.

Figure 10 is a representation of the IMP tungsten grain size with a 350 watt substrate bias and a 100% duty cycle.

Figure 11 is a representative graph of an XRD analysis for a CVD tungsten layer when an underlying IMP TiN layer is exposed to air before depositing the CVD tungsten layer.

Figure 12 is a representative graph of an XRD analysis for a CVD tungsten layer when an underlying IMP tungsten layer is exposed to air before depositing the CVD tungsten layer.

Figure 13 is a representative graph of fluorine diffusion through a Ti/TiN stack.

Figure 14 is a representative graph of fluorine diffusion through a substrate stack according to one embodiment of the present invention with an IMP tungsten layer.

The present invention provides a method of depositing a tungsten-containing material (herein generally referred to as tungsten) on a substrate using a PVD-IMP process for a variety of metallization schemes. In some embodiments, the PVD-IMP tungsten layer is followed by a CVD tungsten layer deposited thereover and in other schemes, the PVD-IMP tungsten layer is followed by deposition of an aluminum or copper layer by PVD, PVD-IMP, CVD, evaporation, electrochemical deposition processes such as electroplating, or other known methods.

**Exemplary PVD-IMP Processing Equipment**

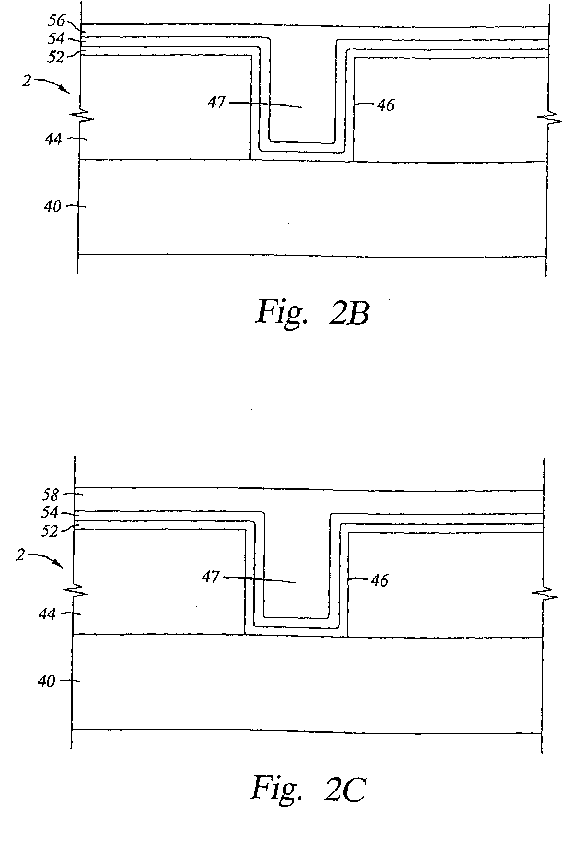

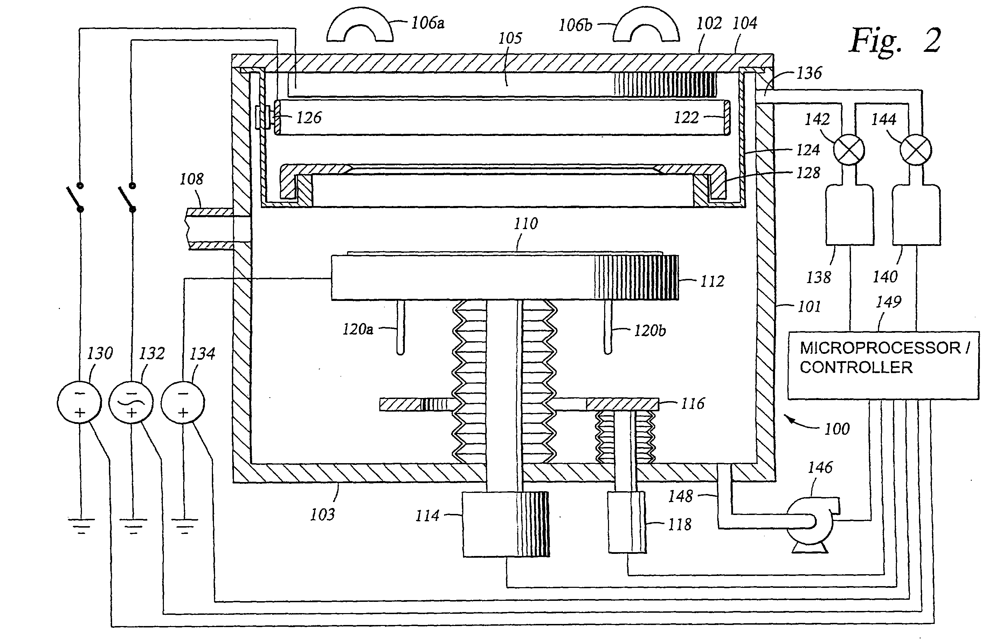

Figure 2 is a schematic cross-sectional view of an ion metal plasma (IMP) chamber 100. An IMP processing chamber, known as an IMP Vectra™ chamber, is available from Applied Materials, Inc. of Santa Clara, California. The IMP chamber can be integrated into an Endura™ platform, also available from Applied Materials, Inc. The chamber 100 includes sidewalls 101, lid 102, and bottom 103. The lid 102 includes a target backing plate 104 which supports a target 105 of the material to be deposited. An opening 108 in the chamber 100 provides access for a robot (not shown) to deliver and retrieve substrates 110 to and from the chamber 100. A substrate support 112 supports the substrate 110 in the chamber and is typically grounded. The substrate support 112 is mounted on a lift motor 114 that raises and lowers the substrate support 112 and a substrate 110 disposed thereon. A lift plate 116 connected to a lift motor 118 is mounted in the chamber 100 and raises and lowers pins 120a, 120b mounted in the substrate support 112. The pins 120a, 120b raise and lower the substrate 110 from and to the surface of the substrate support 112. A coil 122 is mounted between the substrate support 112 and the target 105 and provides inductively coupled electromagnetic fields in the chamber 100 to assist in generating and maintaining a plasma between the target 105 and substrate 110. Power supplied to the coil 122 densifies the plasma which ionizes the sputtered material. The ionized material is then directed toward the substrate 110 and deposited thereon. The term IMP as used herein includes any deposition procedure which ionizes sputtered material for deposition thereof. A shield 124 is disposed in the chamber 100 to shield the chamber sidewalls 101 from the sputtered material. The shield 124 also supports the coil 122 by supports 126. The supports 126 electrically insulate the coil 122 from the shield 124 and the chamber 100. The clamp ring 128 is mounted between the coil 122 and the substrate support 112 and shields an outer edge and backside of the substrate from sputtered materials when the substrate 110 is raised into a processing position to engage the lower portion of the clamp ring 128. In some chamber configurations, the shield 124 supports the clamp ring 128 when the substrate 110 is lowered below the shield 124 to enable substrate transfer.

Three power supplies are used in this type of sputtering chamber. A power supply 130 delivers preferably DC power to the target 105 to cause the processing gas to form a plasma, although RF power can be used. Magnets 106a, 106b disposed behind the target backing plate 104 increase the density of electrons adjacent to the target 105, thus increasing ionization at the target to increase the sputtering efficiency, by generating magnetic field lines generally parallel to the face of the target, around which electrons are trapped in spinning orbits to increase the likelihood of a collision with, and ionization of, a gas atom for sputtering. A power supply 132, preferably a RF power supply, supplies electrical power to the coil 122 to increase the density of the plasma. Another power supply 134, typically a DC power supply, biases the substrate support 112 with respect to the plasma and provides directional attraction of the ionized sputtered material toward the substrate 110.

Processing gas, such as an inert gas of argon or helium or a reactive gas such as nitrogen, is supplied to the chamber 100 through a gas inlet 136 from gas sources 138, 140 as metered by respective mass flow controllers 142, 144. A vacuum pump 146 is connected to the chamber 100 at an exhaust port 148 to exhaust the chamber 100 and maintain the desired pressure in the chamber 100.

A controller 149 generally controls the functions of the power supplies, lift motors, mass flow controllers for gas injection, vacuum pump, and other associated chamber components and functions. The controller controls the power supply 130 coupled to the target 105 to cause the processing gas to form a plasma and sputter the target material. The controller also controls the power supply 132 coupled to the coil 122 to increase the density of the plasma and ionize the sputtered material and the power supply 134 to provide directional attraction of the ionized sputtered material to the substrate surface. The controller 149 executes system control software stored in a memory, which in the preferred embodiment is a hard disk drive, and can include analog and digital input/output boards, interface boards, and stepper motor controller boards (not shown). Optical and/or magnetic sensors (not shown) are generally used to move and determine the position of movable mechanical assemblies.

In operation, a robot (not shown) delivers a substrate 110 to the chamber 100 through the opening 108. The pins 120a, 120b are extended upward, lift the substrate 110 from the robot, and the robot retracts from the chamber 100. The pins 120a, 120b lower the substrate 110 to the surface of the substrate support 112. The substrate support 112 raises the substrate 110 to engage the clamp ring 128. A processing gas is injected into the chamber 100 and a plasma is generated between the target 105 and the substrate support 112 with power from the power supply 130. The power supply 132 delivers power to the coil, which densifies the plasma and ionizes the sputtered target material leaving the target 105 to form sputtered material ions. The sputtered material ions are accelerated toward the biased substrate 110. The process pressure may be operated from about 5 to about 100 mTorr to increase the ionization probability of the sputtered material atoms as the atoms travel through the plasma region. After deposition, the substrate support is lowered, the pins 120a, 120b are raised to lift the substrate 110, a robot (not shown) enters the chamber 100, retrieves the substrate 110, and if desired, delivers another substrate for processing.

## PVD-IMP Tungsten Deposition as Liner, Barrier, and/or Seed Layer

Figure 2A is a schematic cross-sectional view of a device 2 with a tungsten liner/barrier layer of the present invention deposited in a feature 46 formed on the substrate 40. A dielectric layer 44 is deposited on the substrate 40 and etched to form a feature 46, such as a via, contact, trench or line. The term "substrate" is broadly defined as the underlying material upon which the tungsten or other material is deposited. The dielectric layer 44 can be a pre-metal dielectric layer deposited over a silicon wafer or an interlevel dielectric layer.

A liner layer 52 of Ti can be deposited on the dielectric layer 44 as a transition layer to promote adhesion to the underlying material and reduce contact/via resistance. The liner layer is preferably deposited using a PVD-IMP process and can be deposited by other methods such as CVD and other PVD processes, such as collimated or long throw sputtering. Collimated sputtering is generally performed by placing a collimator (not shown) between the target and the substrate to filter sputtered material traveling obliquely through the collimator. Long throw sputtering, also well known in the art, generally is performed by increasing the spacing from the target to the substrate. The extended distance increases the probability that the sputtered material reaching the substrate is directed normal to the substrate surface. In some embodiments, a Ti layer may not be used as a liner layer if the tungsten has sufficient adhesion to the underlying layer for the particular application. Thus, the tungsten could also be deposited as a liner layer 52 without an underlying layer of Ti.

A barrier layer 54 of tungsten, that can also function as a seed layer and a wetting layer, is then deposited over the Ti liner layer 52 using a PVD process, preferably an IMP process. In some applications, an additional barrier layer, such as a TiN layer may be deposited between the Ti liner layer 52 and tungsten barrier layer 54 to provide additional barrier properties. The TiN may be deposited using IMP PVD, other PVD processes and CVD.

An exemplary process regime for the IMP tungsten is as follows for a 200 mm wafer in an IMP chamber such as described in reference to Figure 2. A noble gas, such as helium or argon, is flown into the chamber at a rate sufficient to produce a chamber pressure of about 5 to about 100 mTorr, preferably about 20 mTorr to about 50 mTorr and most preferably about 30 mTorr. The power supply 130 delivers about 200 watts (W) to about 6 kW, preferably about 0.75 kW to about 1.5 kW and most preferably about 1 kW, to a tungsten target 105. The power supply 132 delivers about 500 W to about 5 kW, preferably about 1.5 kW to about 2.5 kW and most preferably about 2 kW, to the coil 122. The power supply 134 delivers about 0 W to about 600 W, preferably about 350 W to about 500 W and most preferably about 450 W, to the substrate support 112 with a duty cycle between 0% to 100% and preferably about 50% to about 100%, and most preferably about 100%. The substrate is maintained at a temperature between about 10°C and about 400°C, preferably below 300°C. Tungsten is deposited on the substrate to a thickness of less than about 2000 Å.

Other tungsten-containing materials, such as tungsten nitride, can be deposited by exposing tungsten to a nitrogen atmosphere in stoichiometric and non-stoichiometric ratios to form tungsten nitride ($WN_x$ where $0<x\leq2$). Tungsten nitride forms a good barrier layer to the diffusion of materials, such as fluorine, aluminum and copper. A tungsten nitride layer can be used in process sequences which traditionally used a TiN layer. A tungsten layer could be deposited over the tungsten nitride layer in accordance with the invention.

One example of a processing regime in which a tungsten nitride layer deposited on a 200 mm substrate is to apply about 1 kW of DC power to a tungsten target 105, about 2 kW of RF power to the coil 122, flow nitrogen at about 26 sccm and argon at about 50 sccm into the chamber 100, and bias the substrate 110 to about 400 watts with a 50% duty cycle although the level of bias is generally not critical. It has been found that the thickness of the tungsten nitride layer preferably should be at least about 150 Å on field areas between features on the substrate and at least about 20 Å on the sidewalls of the features to effectively reduce the diffusion of copper.

The tungsten layer deposited using PVD-IMP has about 1/20 of the resistance of the TiN layer (10 $\mu\Omega$-cm compared to 200-300 $\mu\Omega$-cm). While some aspects of the invention are discussed in reference to an PVD-IMP chamber with a coil disposed therein, it is to be understood that the invention includes other PVD techniques which use ionization of the sputtered flux from a target including hollow cathode magnetron and electron cyclotron resonance techniques.

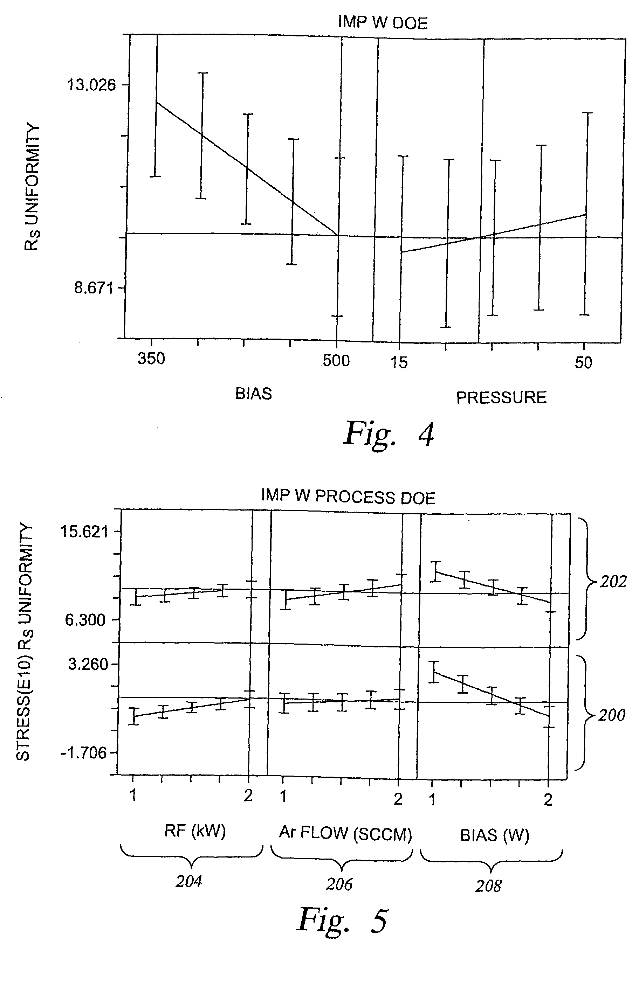

Characteristics of the IMP tungsten layer were investigated for a variety of processing regimes and are described in reference to Figures 4-14 below. For instance, it was discovered that resistance of the layer varies with increasing substrate bias. It was also discovered that the IMP tungsten film stress could be altered between various tensile and compressive stress levels to offset a film stress in other layers of the substrate. Other characteristics such as grain size, air exposure, and diffusion were also investigated.

The deposition of tungsten-containing materials by a PVD or IMP process can be used in several metallization schemes, such as discussed below.

## Metallization Scheme of CVD Tungsten

Figure 2B is a schematic view of a substrate 40 having a feature 46 formed thereon. A liner layer 52 of Ti and a barrier layer 54 of tungsten or tungsten nitride are formed on the pattered surfaces of the dielectric layer 44. Additionally, an intermediate layer of TiN could also be deposited thereon (not shown). The barrier layer 54 is deposited by a PVD process or a PVD-IMP process and provides a nucleation layer for subsequent tungsten growth using a CVD process. One exemplary CVD process includes the hydrogen reduction process in which hydrogen is reacted with $WF_6$ to produce a tungsten layer 56 on the substrate and forms a tungsten plug 47. $WF_6$ attack on the underlying Ti is eliminated by providing PVD W deposition prior to CVD of tungsten. The gas flows and ratios can be varied widely to deposition tungsten and other conductive materials and to produce a chamber pressure between about 1 torr and about 500 torr. Also, the wafer temperature can vary between about 200°C and about 500°C. The layer can be planarized, for instance, by chemical mechanical polishing (CMP) to form a tungsten plug or other feature at any level in the substrate.

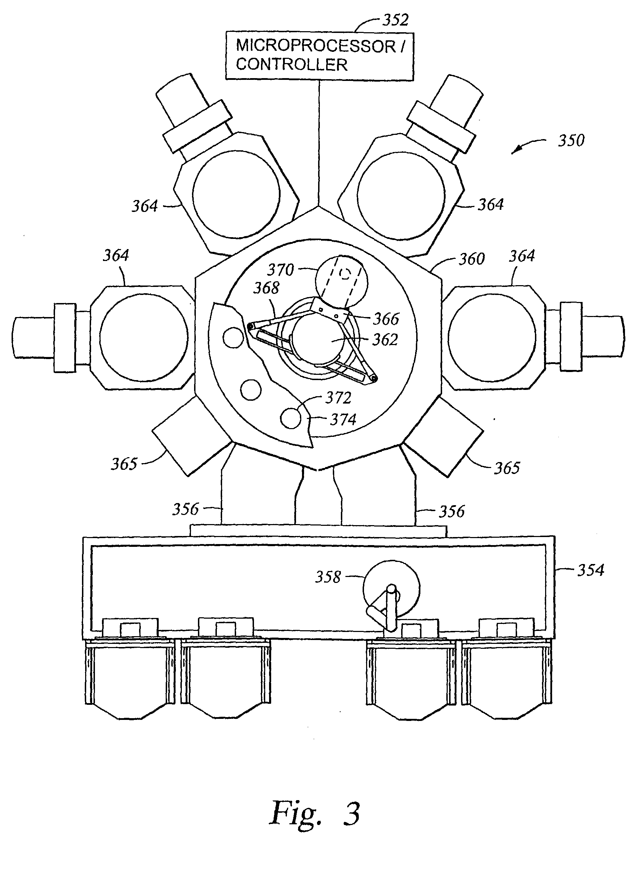

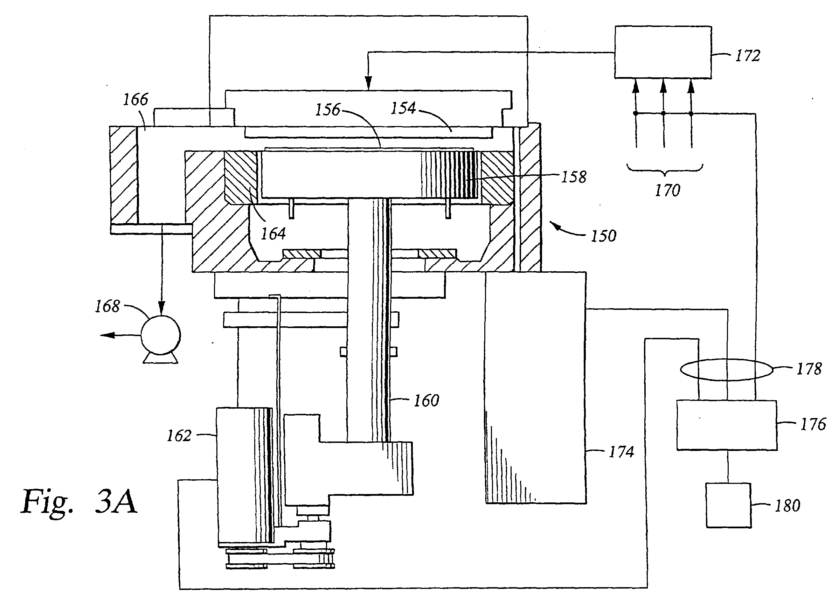

One exemplary CVD tungsten process regime for a 200 mm wafer using a hydrogen reduction process by a thermal reaction in a WxZ™ chamber is described in reference to Figure 3A. The substrate is loaded into the chamber 150 and onto a susceptor 158. The substrate is heated to about 425°C. Argon and hydrogen gases are mixed in the mixing system 172 and flown into the chamber at a rate of about 6000 standard cubic centimeters (sccm) and 6500 sccm, respectively, to increase the chamber pressure to about 300 torr. A spacing of about 400 mils is provided between the substrate and the gas manifold 154. Purge gas, such as hydrogen and argon, may be flown next to the edge of the substrate to assist in controlling deposition on the substrate edge and backside of the substrate. The flow rates of argon and hydrogen are reduced to about 3500 sccm and 1000 sccm, respectively, and the process is stabilized. $WF_6$ is then flowed at a rate of about 250 sccm and mixed with the argon and hydrogen. The gases react and deposit a tungsten layer on the substrate. A backside pressure of about 35 torr is applied to the substrate. The chamber is purged by increasing the argon and hydrogen flow rates to about 6000 sccm and 6500 sccm respectively. The susceptor is lowered and the substrate is removed from the chamber for further processing as desired.

**Metallization Scheme of PVD-IMP Wetting Layer for Aluminum/Copper CVD and PVD Processing**

The present invention can also be used for aluminum deposition processing, including forming a contact. Figure 2C is a schematic view of a substrate 40 having a feature 46 formed thereon. The substrate 40 can have a similar stack of a liner layer 52 of Ti and a barrier layer 54 of tungsten or tungsten nitride, as described in reference to Figure 2A. The liner layer 52 of Ti can be deposited using several processes including PVD processes and preferably an IMP PVD process. The barrier layer 54 of tungsten, deposited by a PVD process and preferably an IMP PVD process, acts as a barrier to prevent reaction of aluminum with Ti. The tungsten layer can also act as a wetting layer for subsequent deposition of aluminum, aluminum/copper alloys, copper, or other conductive materials. Tungsten has been shown to have similar wetting capabilities as TiN for aluminum, as described in "A New Four-Level Metal Interconnect System Tailored to an Advanced 0.5-um BiCMOS Technology" by Ralph N., Wall, IEEE Transactions on Semiconductor Manufacturing, Vol. 11, No. 4, November 1998.

Aluminum, as well as aluminum doped with copper and copper, can generally be deposited by several processes including PVD processes such as IMP, collimated, and long throw sputtering, CVD processes, electroplating, evaporation, or other known methods. At the contact level, two methods particularly used are a flow deposition and a multi-step deposition. In flow deposition, aluminum is deposited onto the substrate with the tungsten liner in a PVD chamber such as the chamber described in reference to Figure 2 without using the coil 122 and associated power supply 132. One simplified process regime for a 200 mm wafer is to flow argon into the chamber at a rate sufficient to create a pressure of about 1 mTorr to about 3 mTorr in the chamber, using the DC power supply 130 to deliver about 500 W to about 2 kW and preferably about 1 kW to about 2 kW to an aluminum target to create a plasma. The substrate temperature is about 425°C to about 500°C. The argon ions dislodge aluminum from the target and the sputtered aluminum material is deposited on the substrate. The substrate is subsequently heated to a temperature of about 500°C to about 550°C to flow the aluminum and fill the contact without having to use a plasma.

In an exemplary multi-step deposition method, using the methods and regimes described herein, a wetting layer, such as a Ti layer, is deposited on a tungsten liner, followed by a "cold", *i.e.*, low temperature, deposition of a conformal aluminum wetting layer, and then a sputter deposition of aluminum to fill the feature and a sputter deposition of a top aluminum layer to improve the aluminum reflectivity for subsequent processing. The cold aluminum wetting layer can be deposited by various techniques. One technique for a 200 mm wafer in a PVD chamber for aspect ratios up to 3:1 includes applying a DC power of about 9 kW to about 12 kW to an aluminum target, flowing argon or some other inert gas into the chamber sufficient to create a chamber pressure of about 1 mTorr to about 3 mTorr. The wafer temperature is about 50°C or less during the deposition.

The aluminum material and other materials can be deposited also by a CVD process. For instance, a CVD process could be used to form the wetting layer of aluminum in the multi-step deposition process. The CVD process could also be used to fill the feature. However, preferably, the CVD process is used to create the aluminum wetting layer which is then followed by PVD of aluminum to fill the feature. A CVD process for aluminum could include the use of dimethyl aluminum hydride ("DMAH") and hydrogen as precursor gases according to the following equation:

$$(CH_3)_2Al\text{-}H + H_2 \rightarrow Al + CH_4 + H_2$$

An exemplary CVD chamber is described in reference to Figure 3A. An exemplary process regime is as follows for depositing a wetting layer of aluminum. DMAH and hydrogen gas are flown into a CVD chamber 150 to establish a chamber pressure of between about 1 torr and about 80 torr and preferably about 23 mTorr to about 27 mTorr. An inert gas, such as argon or helium, is flown into a CVD chamber 150 to establish a pressure below the substrate, *i.e.*, backside pressure, of about 9 torr to about 11 torr. The wafer is heated to about 200°C to about 250°C and a wafer to gas distribution manifold 154 spacing is set at about 320 mils to about 370 mils through which the DMAH is flown. A CVD wetting layer thickness of about 500 Å to about 700 Å is sufficient to wet a subsequent sputtering process.

After the wetting layer is formed by either of the two deposition methods described above, a PVD process is used to sputter aluminum from an aluminum target to fill the feature. An exemplary process regime uses a DC power supply, such as power supply 130 in the chamber 100 shown in Figure 2, to supply about 1 kW to about 2 kW to an aluminum target and flowing argon or some other inert gas into the chamber sufficient to create a chamber pressure of about 1 mTorr to about 3 mTorr. The wafer temperature is about 375°C to about 500°C during the deposition. A top layer of aluminum of about 1000 Å to about 2000 Å is deposited thereafter preferably by sputtering to improve the reflectivity of the aluminum fill layer for subsequent processing. The primary difference in the sputtering regime of the aluminum top layer is an increase in DC power to the target of about 9 kW to about 12 kW.

Alternatively, the aluminum deposition can occur directly on the tungsten liner/barrier layer instead of the Ti wetting layer. The tungsten provides wetting capabilities for the aluminum. An advantage is that tungsten has less resistivity than Ti and thus reduces the overall stack resistivity. Also, eliminating the Ti layer simplifies the overall process.

A similar metallization scheme can apply to the deposition of copper, copper containing materials, and aluminum/copper alloys. For instance, a CVD copper wetting layer can be deposited over the Ti and/or tungsten layer followed by a PVD-IMP deposition of copper.

A CVD copper wetting layer may be deposited using by any known CVD copper process or precursor gas, including $Cu^{+2}(hfac)_2$ and $Cu^{+2}(fod)_2$ (fod being an abbreviation for heptafluoro dimethyl octanediene), but preferably, the process uses the volatile liquid complex copper$^{+1}$hfac,TMVS (hfac being an abbreviation for the hexafluoro acetylacetonate anion and TMVS being an abbreviation for trimethylvinylsilane) with argon as the carrier gas. Because this complex is a liquid under ambient conditions, it can be utilized in standard CVD bubbler precursor delivery systems currently used in semiconductor fabrication. Both TMVS and copper$^{+2}$(hfac)$_2$ are volatile byproducts of the deposition reaction that are exhausted from the chamber. The deposition reaction is believed to proceed according to the following mechanism, in which (s) denotes interaction with a surface and (g) denotes the gas phase.

$$2Cu^{+1}hfac,TMVS(g) \longrightarrow 2Cu^{+1}hfac,TMVS(s) \qquad \text{step (1)}$$

$$2Cu^{+1}hfac,TMVS(s) \longrightarrow 2Cu^{+1}hfac(s) + 2TMVS(g) \qquad \text{step (2)}$$

$$2Cu^{+1}hfac(s) \longrightarrow Cu(s) + Cu^{+2}(hfac)_2(g) \qquad \text{step (3)}$$

In step 1, the complex is adsorbed from the gas phase onto a metallic surface. In step 2, the coordinated olefin (TMVS in this specific case) dissociates from the complex as a free gas leaving behind $Cu^{+1}$hfac as an unstable compound. In step 3, the $Cu^{+1}$hfac disproportionates to yield copper metal and volatile $Cu^{+2}(hfac)_2$. The disproportionation at CVD temperatures appears to be most strongly catalyzed by metallic or electrically conducting surfaces. In an alternative reaction, the organometallic copper complex can be reduced by hydrogen to yield metallic copper.

The volatile liquid complex, $Cu^{+1}$hfac,TMVS, can be used to deposit copper through either a thermal or plasma based process. The substrate temperature for the plasma enhanced process is preferably between about 100°C and about 400°C, while that for the thermal process is between about 50°C and about 300°C, most preferably about 170°C. Following either of these processes, a CVD copper wetting layer, such as Ti or Ta or tungsten, may be provided over the nucleation layer. Alternatively, electroplated copper may be used in combination with or in replacement of the CVD copper wetting layer.

Following deposition of a copper wetting layer, the substrate is sent to a PVD-IMP chamber to sputter deposit copper below the melting point temperature of the copper. It is preferred that the PVD-IMP copper be deposited at a substrate temperature below about 550°C, preferably below about 400°C. The copper layers start to flow during the PVD deposition process at above 200°C. A substrate temperatures above the melting point of aluminum (>660°C) is not required with the wetting layer. Therefore, the application of a thin wetting layer enables planarization of the copper to be achieved at temperatures below the melting point of the copper. The CVD copper process is explained more fully in co-pending U.S. Appl. No. 08/792,292 entitled "Low Temperature Integrated Via And Trench Fill Process And Apparatus", filed January 31, 1997 and is incorporated herein by reference.

The tungsten can also form a seed layer for other deposition techniques. For example, it is believed that copper can be deposited over the seed layer by applying an electrical current to the edge of the tungsten layer and plating copper from an electrolytic solution. One such system that can be used to advantage is an Electra™ Cu ECP system, available from Applied Materials, Inc. of Santa Clara, California. It is also believed that a layer of tungsten can be deposited by an electroplating process on the tungsten seed layer by techniques similar to techniques used in electroplating copper and other conductive materials.

## System Equipment

The PVD-IMP chamber of Figure 2 can be incorporated into an integrated processing system having multiple chambers. Figure 3 is a schematic top view of an exemplary processing system 350. A portion of the lid 374 has been cut away to reveal details of the processing system 350. The processing system 350 is typically known as a cluster tool. Two such systems are the Centura® and the Endura® systems, both available from Applied Materials, Inc. The details of one such staged-vacuum substrate processing system is disclosed in United States Patent No. 5,186,718, entitled "Staged-Vacuum Wafer Processing System and Method," Tepman et al., issued on February 16, 1993, which is incorporated herein by reference. The exact arrangement and combination of the chambers may be altered for purposes of performing specific steps of a fabrication process.

The processing system 350 generally comprises a plurality of chambers and robots and is preferably equipped with a microprocessor/controller 352 programmed to control the various processing methods performed in the processing system 350. A front-end environment 354 is shown positioned in selective communication with a pair of load lock chambers 356. A pod loader 358 disposed in the front-end environment 354 is capable of linear and rotational movement to shuttle cassettes of substrates to and from the load locks 356. The load locks 356 provide a first vacuum interface between the front-end environment 354 and a transfer chamber 360. A robot 362 is centrally disposed in the transfer chamber 360 to transfer substrates from the load locks 356 to one of the various processing chambers 364 and service chambers 365. The robot 362 is a frog-leg type robot capable of extension, retraction, and rotation and is actuated by a stepper motor. A support member 366 connected to the robot linkage 368 is adapted to support a substrate 370 during transfer through the transfer chamber 360 and between the chambers 364, 365 and the load locks 356. The processing chambers 364 may perform any number of processes such as PVD, CVD, electroplating and etching while the service chambers 365 are adapted for degassing, orientation, cool down and the like. A number of view ports 372 formed in a lid 374 of the transfer chamber 360 provide visual access into the transfer chamber 360. While the above system is exemplary, the invention has application in any arrangement that requires the deposition of tungsten, aluminum, copper, and other materials, and, thus, it is understood that other applications of the invention are contemplated.

Figure 3A is a schematic cross section view of an exemplary CVD chamber 150 that can be used in the processing system 350. One suitable CVD plasma reactor in which a CVD layer can be deposited is a WxZ™ chamber, also available from Applied Materials, Inc. Chamber 150 contains a gas distribution manifold 154 for dispersing process gases through perforated holes (not shown) in the manifold to a substrate 156 that rests on a substrate support plate or susceptor 158.

Susceptor 158 is resistively heated and mounted on a support stem 160 so that susceptor 158 (and the substrate 156 supported on the upper surface of susceptor 158) can be controllably moved by a lift motor 162 between a lower loading/off-loading position and an upper processing position which is closely adjacent to the manifold 154.

When susceptor 158 and the substrate 156 are in the processing position, they are surrounded by a ring 164. During processing, gases inlet to manifold 154 are uniformly distributed radially across the surface of the substrate 156. The gases exhaust through a port 166 by a vacuum pump system 168 having a throttle valve (not shown) to control exhaust rate of gas from the chamber 150.

Before reaching manifold 154, deposition and carrier gases are input through gas supply lines 170 into a mixing system 172 where they are combined and then sent to manifold 154. Generally, the process gas supply lines 170 for each of the process gases include i) safety shut-off valves (not shown) that can be used to automatically or manually shut off the flow of process gas into the chamber 150, and ii) mass flow controllers (also not shown) that measure the flow of gas through the gas supply lines 170. When toxic gases are used in the process, several safety shut-off valves are positioned on each gas supply line in conventional configurations.

In a plasma enhanced process, a controlled plasma is formed adjacent to the substrate 156 by RF energy applied to the manifold 154 from RF power supply 174 (with susceptor 158 grounded). Gas distribution manifold 154 is also an RF electrode, while susceptor 158 is grounded. RF power supply 174 scan supply either single or mixed frequency RF power to manifold 154 to enhance the decomposition of reactive species introduced into chamber 150. A mixed frequency RF power supply typically supplies power at a high RF frequency (RF1) of 13.56 MHz and at a low RF frequency (RF2) of 350 kHz.

Heat is provided to the susceptor 158 by a resistive heat coil embedded in the susceptor 158. This additional heat compensates for the natural heat loss pattern of the susceptor and provides rapid and uniform susceptor and substrate heating for effecting deposition.

Typically, any or all of the chamber lining, gas inlet manifold faceplate, support stem 160, and various other reactor hardware is made out of material such as aluminum or aluminum oxide. An example of such a CVD reactor is described in U.S. Patent No. 5,000,113, entitled "Thermal CVD/PECVD Reactor and Use for Thermal Chemical Vapor Deposition of Silicon Dioxide and *In-situ* Multi-step Planarized Process," issued to Wang et al., incorporated herein by reference, and assigned to Applied Materials, Inc., the assignee of the present invention.

The lift motor 162, the gas mixing system 172, and the RF power supply 174 are controlled by a system controller 176 over control lines 178. The reactor includes analog assemblies such as mass flow controllers (MFCs), RF generators, and lamp magnet drivers that are controlled by the system controller 176 which executes system control software stored in a memory 180, preferably a hard disk drive. Motors and optical sensors (not shown) are used to move and determine the position of movable mechanical assemblies such as the throttle valve of the vacuum system 168 and motor for positioning the susceptor 158.

The system controller 176 controls all of the activities of the CVD reactor and a preferred embodiment of the controller 176 includes a hard disk drive, a floppy disk drive, and a card rack (not shown). The card rack contains a single board computer (SBC), analog and digital input/output boards, interface boards and stepper motor controller boards. The system controller 176 conforms to the Versa Modular Europeans (VME) standard which defines board, card cage, bus structure, and connector dimensions and types.

The system controller 176 operates under the control of a computer program stored on the hard disk drive 180. The computer program dictates the timing, mixture of gases, RF power levels, susceptor position, and other parameters of a particular process.

Several aspects of the present invention were investigated using chambers and systems similar to the chambers and processing system shown in Figures 2, 3, and 3A and are described below.

## Investigated Characteristics of IMP PVD Tungsten Deposition

The IMP tungsten deposition process was investigated using a Vectra™ chamber from Applied Materials, Inc. The process included providing an argon flow in a Vectra™ IMP chamber to achieve a pressure between about 10 and about 100 mTorr. A design of experiments, referred to as a DOE, was conducted to characterize the IMP tungsten process performance. In a typical DOE, a single parameter is changed while other parameters remain constant and the results and trends are charted. Unless otherwise stated, the DC power applied to the target 105 shown in Figure 3A was set at about 1000 watts to establish a suitable deposition rate for the experiments below. Coil RF power, substrate bias DC power, and process pressure were varied and the resulting IMP tungsten sheet resistance uniformity, deposition rate, and film stress were characterized. The DOE characterization is shown in Figures 4 and 5 and the resulting characteristics of the films from various combinations of parameters are described below.

## Sheet Resistance Uniformity

Figure 4 is a graph of the sheet resistance uniformity for films formed using different process parameters. Figure 4 shows the effects of varying the substrate bias while the chamber pressure is held constant during processing and the effects of varying the pressure while the substrate bias is held constant. The film uniformity was about 4% to about 7%. The sheet resistance uniformity improves with increasing substrate bias. Also, the sheet resistance uniformity improves with decreasing process pressure.

A higher substrate bias in IMP tungsten processing results in a significant improvement in uniformity. The sheet resistance uniformity of a substrate was measured by applying a substrate bias of about 350 watts DC to the substrate, applying a target bias of about 1000 watts DC to the target, and applying about 2000 watts RF to the IMP coil. The chamber pressure was maintained at about 30 mTorr. At those parameters, the sheet resistance uniformity was measured, resulting in a value of about 11%. By changing the substrate bias to about 500 watts while maintaining the target bias at about 1000 watts, the coil bias at about 2000 watts, and the chamber pressure at about 30 mTorr, the uniformity improved to about 5%. Thus, the uniformity was improved about 6% by adjusting the substrate DC bias.

## Film Stress

The stress of the tungsten deposition was also investigated. Stress on the film caused by deposition conditions can be tensile which would typically tend to bend the film in a concave manner, that is, the film edges bend away from the underlying surface or layer on which the film is deposited and may cause delamination of the film from the underlying layer. The stress can also be compressive which would typically tend to bend the film in a convex manner, that is, the inner surfaces of the film bend away from underlying surface or layer and may cause delamination of the inner surfaces of the film layer from the underlying surface or layer.

Figure 5 is a graph of film stress relative to different process parameters, such as a coil bias between about 100 watts to about 200 watts, an Ar flow between about 35 sccm to about 85 sccm, and a substrate bias between about 0 watts to about 500 watts. The y-axis indicates that the tungsten film stress can be controlled by varying the parameters shown on the x-axis. The lower set of lines in zone 200 represents the stress results of an IMP tungsten layer deposited with variations in RF power levels delivered to the IMP coil in zone 204, argon flow as the process gas in zone 206, and substrate bias in zone 208.

The inventors have discovered that the film stress level is tunable and can be significantly lowered compared to traditional PVD processing. The IMP process for tungsten disclosed herein was able to reverse the stress from a tensile to a compressive level.

An increase in the RF power to the coil, holding the argon flow and substrate bias constant, increased the compressive stress while decreasing the tensile stress of the film. An increase in argon flow, holding the RF power and substrate bias constant, increased the tensile stress of the film. An increase in substrate bias, holding the RF power and argon flow constant, decreased the tensile stress, reversed the stress to a compressive stress, and then increased the compressive stress. For instance, the stress on a substrate was measured when a substrate bias at about 0 watts was applied to a substrate and a coil bias of about 1000 watts was applied to the IMP coil. Argon was flown into the processing chamber at a flow rate of about 65 sccm. The parameters resulted in a stress level of about $3.3 \times 10^{10}$ dyne/cm$^2$ tensile. With a coil bias of about 2000 watts and maintaining the argon flow rate and substrate bias at about the same values, the stress was about $2.6 \times 10^{10}$ dyne/cm$^2$ tensile.

At an argon flow rate of about 35 sccm and maintaining the RF power to the coil at about 2000 watts and substrate bias at about 0 watts, the stress level was about $2.1 \times 10^{10}$ dyne/cm$^2$ compressive. By changing the argon flow rate to about 65 sccm and maintaining the RF power and substrate bias constant, the stress changed to about $2.6 \times 10^{10}$ dyne/cm$^2$ tensile.

The inventors discovered that the substrate bias power is a significant factor in controlling the film stress. For instance, by applying a substrate bias of about 0 watts to the substrate and delivering about 2000 watts RF to the coil and flowing argon at a flow rate of about 85 sccm, the film stress was about $3.0 \times 10^{10}$ dyne/cm$^2$ tensile. By changing the substrate bias to about 500 watts and maintaining the RF power and argon flow rate constant, the film stress changed to about $1.5 \times 10^{10}$ dyne/cm$^2$ compressive.

The results show that the present invention can be used to advantage to achieve an overall lower stress level of the stack by tuning the IMP tungsten layer to an appropriate offsetting stress, either tensile or compressive, to counterbalance other stresses in the multilevel stack caused by the various layer depositions. The amount of substrate bias can change the stress levels from a tensile stress to a compressive stress and vice versa. An overall low stress level is desired to prevent fracture and delamination of the film stack and to improve overall device reliability.

**Step Coverage**

The inventors discovered that the sidewall coverage of IMP tungsten was significantly higher than Ti and TiN, approximating two times the sidewall coverage of Ti and TiN. A thicker sidewall coverage is highly desired for IMP tungsten to be an effective barrier to protect the underlying Ti layer from $WF_6$ attack during the subsequent CVD tungsten growth. The bottom coverage, especially in the corners and even in quarter-micron features with a 4:1 aspect ratio, was at least about 20% and typically about 40% to about 52%, which approximates three times the bottom coverage of traditional PVD processing for tungsten. The present invention also provides higher deposition rates for tungsten, approximating four times the deposition rate of TiN.

Generally, applying a substrate bias to increase the ion energies flattened the bottom step coverage profile of the IMP tungsten layer. It is believed that the more energetic ions re-sputtered the sputtered material on the bottom center of the feature and re-deposited the material at the bottom corners to obtain the flatter profile. Thus, in using an IMP process, the substrate bias shapes the deposition on the substrate top and bottom corners and minimizes overhang at the opening of the features. Because tungsten growth from the subsequent selective CVD deposition occurs from tungsten surfaces deposited in the IMP tungsten process, an overhang at the opening of the feature could cause the CVD tungsten to pinch off at the opening before the feature was completely filled, resulting in a void in the feature. Also, the overhang at the top corners could interfere with bottom coverage uniformity. It is believed that the top corners are also re-sputtered with the more energetic ions as the substrate bias increases to reduce the overhang.

Film Resistivity Compared to Film Thickness

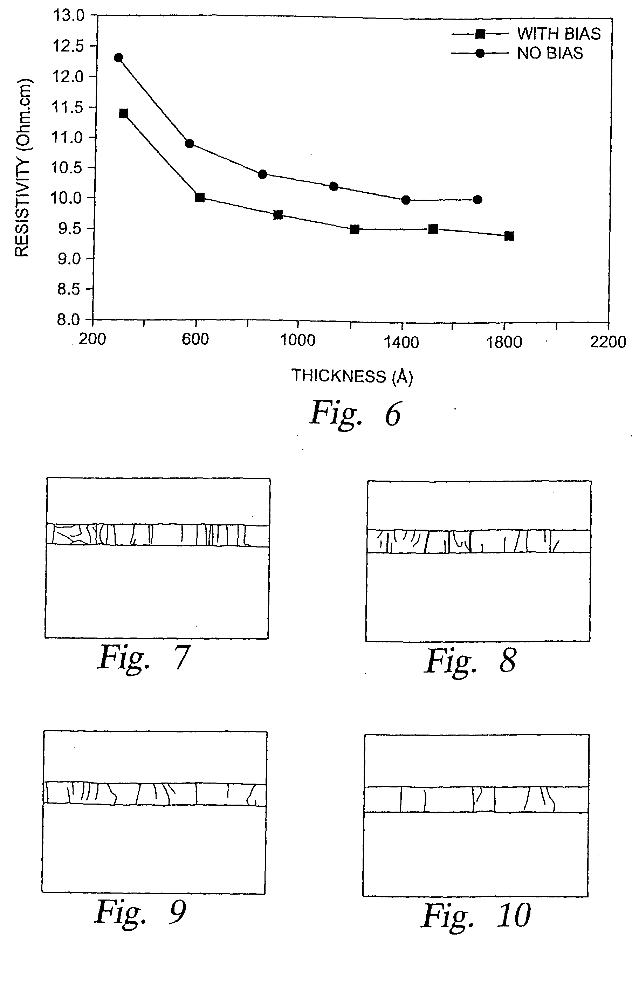

The film resistivity was also investigated. Figure 6 is a graph of the film resistivity relative to the film thickness with and without a substrate bias. The substrate bias used was about 350 watts of DC bias power with a 50% duty cycle, the target bias was about 1000 watts of DC power, the coil bias was about 1500 watts of RF power, and the process pressure was about 16 mTorr. Figure 6 shows that the film resistivity was higher for thin films and decreased as the film thickness increased and that applying a substrate bias reduced the resistivity of the substrate.

Other tests on resistivity revealed that a PVD-IMP/CVD tungsten stack has lower resistivity than an PVD-IMP TiN/CVD tungsten stack. The underlying PVD-IMP tungsten layer provided the lower and more desirable overall resistance of the substrate stack and even a lower CVD tungsten resistance than the CVD tungsten on the PVD-IMP TiN layer. Table 1 shows the tests measurements on the PVD-IMP TiN/CVD tungsten stack compared to the PVD-IMP tungsten/CVD tungsten stack.

TABLE 1

| Stack | Total (Å) | R$_s$ Overall (Ω-sq.) | CVD W (Å) | Under Layer (Å) | Under Layer R$_s$ (Ω-sq.) | CVD W R$_s$(Ω-sq.) | CVD W Resist. (μΩ-cm) | CVD W Grain Orient. |
|---|---|---|---|---|---|---|---|---|
| CVD W/PVD IMP TiN | 5347 | 0.2173 | 4747 | 600 | 14 | 0.2207 | 10.5 | 200 |
| CVD W/PVD-IMP W | 4737 | 0.1951 | 4237 | 500 | 2 | 0.2162 | 9.16 | 110 |

The overall resistivity of the first stack, having a CVD tungsten layer of about 4747 Å thick deposited on a 600 Å thick PVD-IMP TiN layer for a total thickness of about 5347 Å, was about 0.2173 Ω-sq. The overall resistivity of the second stack, having a CVD tungsten layer of about 4237 Å thick deposited on a 500 Å thick PVD-IMP tungsten layer for a total thickness of 4737 Å, was about 0.1951 $\Omega$-sq. Sheet resistance of the 600 Å PVD-IMP TiN layer was about 14 $\Omega$-sq. and sheet resistance of the 500 Å PVD-IMP tungsten layer was about 2 $\Omega$-sq. The sheet resistance of the CVD tungsten layer on the PVD-IMP TiN was measured at 0.2207 $\Omega$-sq. The sheet resistance of the CVD tungsten layer on the PVD-IMP tungsten was measured at 0.2162 $\Omega$-sq. Using those figures, the resistivity of the CVD tungsten on the IMP TiN layer was about 10.5 $\mu\Omega$-cm. In contrast, the resistivity of the CVD tungsten layer on the PVD-IMP tungsten layer was about 9.16 $\mu\Omega$-cm. It is believed the results are due to the CVD tungsten epitaxial grain growth on the IMP tungsten as well as larger grain size between the CVD tungsten deposited on the PVD-IMP TiN compared to the PVD-IMP tungsten. The resistivity of tungsten decreases with increasing grain size. The grain size of CVD tungsten on a PVD-IMP tungsten seed layer was about 0.3 $\mu$m. By comparison, the grain size of CVD tungsten on a PVD-IMP TiN seed layer is typically about 0.1 $\mu$m.

**Grain Size of IMP Tungsten**

Figures 7-10 are cross-sectional scanning electron microscopy (SEM) photographs, representing the effect of substrate bias and bias duty cycle on grain size. The larger the grain size, the less the resistivity of the layer due to less grain boundary layers for the electrons to traverse. Figure 7 represents the IMP tungsten grain size without using a substrate bias. Figure 8 represents the IMP tungsten grain size with a substrate bias of about 350 watts and a 50% duty cycle and is larger than the grain size deposited without using a substrate bias as shown in Figure 7. Figure 9 represents the IMP tungsten grain size using a substrate bias of about 500 watts and a 50% duty cycle and is even larger than the grain size deposited using 350 watts and a 50% duty cycle as shown in Figure 8. Figure 10 represents the IMP tungsten grain size deposited using about 350 watts of substrate bias and a 100% duty cycle, where the grain size is larger than the grain size deposited using about 350 watts of substrate bias and a 50% duty cycle as shown in Figure 8. The grain size using a substrate bias of about 350 watts and a 100% duty cycle as shown in Figure 10 also appears larger compared to the grain size deposited using a substrate bias of about 500 watts and a 50% duty cycle as shown in Figure 9. It is believed that the higher intensity from either the increased substrate bias and/or the higher duty cycle contributes to a denser grain structure with less defects that affects the boundary layer formation and results in larger grain sizes.

**Air Exposure on CVD Tungsten Layer**

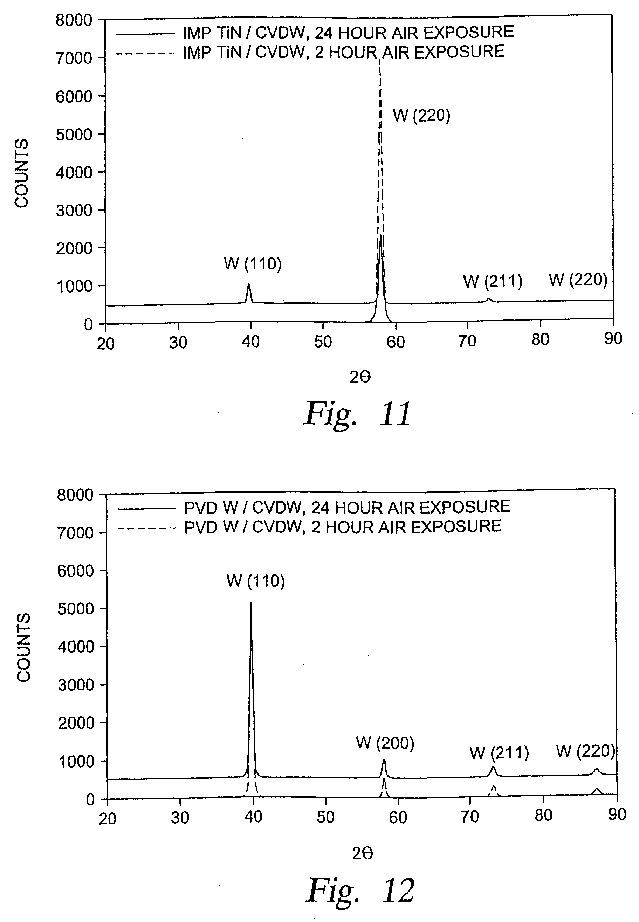

The effect of air exposure on the tungsten layer after an IMP TiN and IMP tungsten process is shown in the graphs of XRD analyses of Figures 11 and 12. The XRD analyses indicate the grain orientation of the CVD tungsten after the IMP layer was exposed to air for a period of time. An air exposure could occur due to a delay in processing between depositing the IMP layer and before depositing the CVD layer. Preferably, the substrate is less sensitive to air exposures for better manufacturability.

Figure 11 is a graph of an XRD analysis for a CVD tungsten layer having an underlying IMP TiN layer exposed to air before the CVD tungsten deposition. The IMP TiN layer was exposed to air for about two hours before a subsequent CVD tungsten layer was deposited on the IMP layer and then the grain structure of the CVD layer was analyzed. The results of the two hour air exposure are represented by a dashed line. Similarly, the effect on the grain structure of a CVD tungsten layer from about a 24 hour air exposure on the underlying IMP TiN layer is represented by a solid line. The solid line is offset by 500 counts from the dashed line to view both lines on the same graph. The IMP TiN/CVD tungsten structure with a two hour exposure has a structure of no counts for a grain orientation of 110, about 6300 counts for a grain orientation of 200, and no counts for either grain orientation 211 or 220. The 24 hour exposure changed the structure significantly, demonstrating that the process was air sensitive in that an air exposure on the IMP TiN layer would cause a change in the grain structure of the subsequent CVD tungsten layer. The results show a grain orientation of about 500 counts of a grain orientation of 110, about 1750 counts of a grain orientation of 200, about 150 counts of a grain orientation of 211, and about 50 counts of a grain orientation of 220.

Figure 12 shows representative results of an XRD for an IMP tungsten layer exposed to air for about two hours and about 24 hours before depositing the CVD tungsten layer. The dashed line represents the results on the grain structure with the two hour exposure and the solid line represents the results on a grain structure with the 24 hour exposure, where again the solid line is offset by 500 counts from the dashed line. The grain structure of the CVD layer with the two hour exposure to the IMP layer resulted in about 4500 counts of a grain orientation of 110, about 500 counts of a grain orientation of 200, about 200 counts of a grain orientation of 211, and about 100 counts of a grain orientation of 220. In contrast to the IMP TiN results of Figure 11, even the 24 hour results did not change the grain orientations significantly, if at all, demonstrating that the process is stable, so that desirable process conditions could be maintained regardless of the air exposure.

**Fluorine Diffusion through IMP/CVD Tungsten**

The difference in fluorine diffusion barrier properties of IMP tungsten compared to IMP TiN was also investigated. As described herein, fluorine diffusion can form compounds which create "volcanoes" that fracture the barrier film.

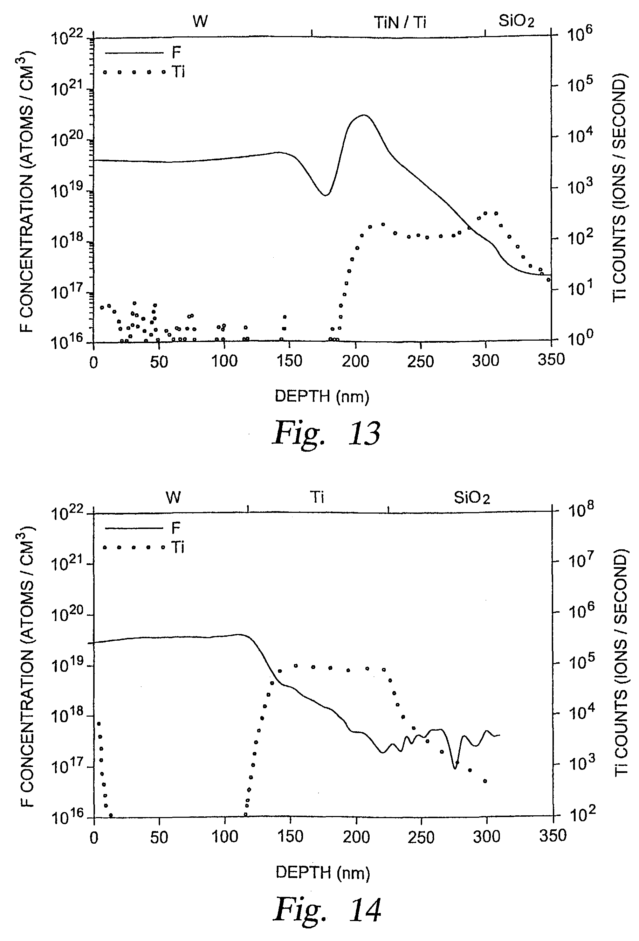

Figure 13 is a representative graph of fluorine diffusion through a Ti/TiN stack. Figure 13 shows fluorine concentration in atoms/cm$^3$ to demonstrate fluorine diffusion through a substrate stack having a silicon oxide dielectric layer, about a 1000 Å thick layer of IMP Ti deposited thereon, about a 100 Å thick layer of IMP TiN deposited on the IMP Ti layer, and CVD tungsten deposited on the TiN layer at about 425°C, using the WF$_6$ chemistry described herein. The stack was polished by CMP processes to improve the depth profile accuracy. The fluorine level, shown in Figure 13, in the CVD tungsten layer was about 4 x 10$^{19}$ atoms/cm$^3$ and began reducing near the tungsten/TiN interface. The TiN film acts as a barrier and slows the fluorine diffusion. The solubility of fluorine in TiN is lower than in either tungsten or Ti and is shown by the drop in concentration. As the fluorine diffuses into the Ti, the concentration increases to about 3 x 10$^{20}$ atoms/cm$^3$ in the TiN/Ti region at a depth of about 2000 Å from the surface and then reduces logarithmically to a level of about 1 x 10$^{18}$ atoms/cm$^3$ near the Ti/SiO$_2$ interface. The area under the curve in the region between the tungsten/TiN interface and the Ti/SiO$_2$ interface can be integrated to determine a "dosage level" of fluorine in that region. The dosage level in Figure 13 for that region is about 5 x 10$^{14}$ atoms/cm$^2$.

By contrast, Figure 14 is a graph of the fluorine concentration of one structure made in accordance with the present invention, having a silicon oxide dielectric layer, about a 1000 Å thick layer of IMP Ti deposited thereon, about a 100 Å thick IMP tungsten barrier layer deposited on the Ti layer, and a CVD tungsten layer deposited on the IMP tungsten barrier layer. The substrate stack was likewise polished with a CMP process. The concentration of fluorine in the IMP/CVD tungsten films is about 3 x 10$^{19}$ atoms/cm$^3$, similar to the starting level shown in Figure 13, but does not significantly rise in the Ti film like the level in Figure 13 nor does the fluorine concentration extend as deep as the concentration shown in Figure 13. The concentration reduces to about 1 x 10$^{17}$ atoms/cm$^3$ near the Ti/SiO$_2$ interface at a depth of about 2200 Å from the stack surface. Integrating the area under the curve to obtain the dosage level in the Ti film yields about 3 x 10$^{13}$ atoms/cm$^2$, a level that is about an order of magnitude less than the sample with the TiN/Ti combination shown in Figure 13. Thus, the IMP tungsten film is a significantly better barrier to fluorine diffusion from a subsequent CVD tungsten process than the IMP TiN film.

While the foregoing is directed to the preferred embodiment of the present invention, other and further embodiments of the invention may be devised without departing from the basic scope thereof, and the scope thereof is determined by the claims that follow.

**Claims**

**1.** A method of depositing tungsten on a substrate, comprising:

a) sputtering tungsten from a target;
b) passing at least a portion of the sputtered tungsten through an electromagnetic field disposed between the target and a substrate; and
c) attracting the tungsten to the substrate to form a first tungsten layer.

**2.** A method as claimed in claim 1, wherein passing at least a portion of the sputtered tungsten through the electromagnetic field comprises using an ionized metal plasma (IMP) process.

**3.** A method as claimed in claim 1 or claim 2, further comprising depositing a second tungsten layer by a chemical vapor deposition (CVD) process on the first tungsten layer.

**4.** A method as claimed in claim 3, wherein the chemical vapor deposition process of the second tungsten layer includes a hydrogen reduction of tungsten hexafluoride.

**5.** A method as claimed in any of claims 1 to 4, further comprising depositing a liner layer of a titanium material prior to forming the first tungsten layer.

**6.** A method as claimed in any of claims 1 to 5, further comprising exposing the tungsten to nitrogen to deposit a tungsten nitride layer.

**7.** A method as claimed in any of claims 1 to 6, further comprising adjusting a stress level of the first tungsten layer by adjusting a substrate bias applied to the substrate.

**8.** A method as claimed in claim 7, wherein adjusting the stress level comprises lowering an overall substrate stress by tuning the first tungsten layer stress level.

**9.** A method as claimed in any of claims 1 to 8, further comprising increasing a film thickness uniformity of the first tungsten layer by increasing a substrate bias applied to the substrate.

**10.** A method as claimed in any of claims 1 to 9, further comprising depositing at least about 20% of the field coverage on the substrate in the bottom of a feature on the substrate by adjusting a substrate bias applied to the substrate.

**11.** A method as claimed in any of claims 1 to 10, further comprising reducing the resistance of the substrate by increasing a substrate bias applied to the substrate.

**12.** A method as claimed in any of claims 1 to 11, further comprising depositing a conductive material over the first tungsten layer, the conductive layer comprising copper, aluminium, tungsten or combinations thereof.

**13.** A substrate, comprising a first tungsten layer deposited on the substrate produced by an ionization of sputtered tungsten material.

**14.** A substrate as claimed in claim 13 or claim 14, further comprising a layer of titanium material disposed on the substrate prior to the first tungsten layer.

**15.** A substrate as claimed in any of claims 13 to 16, wherein the first tungsten layer comprises tungsten nitride.

**16.** A substrate as claimed in any of claims 13 to 17, wherein the substrate comprises at least one layer of conductive metal or allows thereof deposited over at least one tungsten layer.

**17.** A substrate as claimed in any of claims 13 to 16, further comprising a second tungsten layer deposited on the first tungsten layer by a CVD process.

**18.** A substrate as claimed in any of claims 13 to 16, wherein the second tungsten layer comprises a hydrogen reduction of tungsten hexafluoride.

**19.** A substrate as claimed in any of claims 13 to 16, further comprising a second tungsten layer deposited on the first tungsten layer by an electrochemical deposition process.

**20.** A substrate as claimed in any of claims 17 to 19, wherein the second tungsten layer has no substantial grain orientation change when the first tungsten layer is exposed to air for at least about 24 hours.

**21.** A substrate as claimed in any of claims 17 to 20, wherein the first tungsten layer and second tungsten layer are deposited in a feature on the substrate.

**22.** A substrate as claimed in claim 21, wherein the feature comprises a plug on the substrate.

**23.** A substrate as claimed in any of claims 13 to 22, wherein the film thickness uniformity of the first tungsten layer deposited in the bottom of a feature is 8% or less.

**24.** A substrate as claimed in any of claims 13 to 22, wherein bottom coverage of the first tungsten layer deposited in a feature is about 20% or greater compared to the coverage of the substrate in field areas.

**25.** A substrate as claimed in any of claims 13 to 24, wherein a stress level of the substrate stack measured prior to the deposition of the first tungsten layer has been lowered by an offsetting stress level in the first tungsten layer measured after the deposition of the first tungsten layer.

**26.** A substrate as claimed in any of claims 13 to 25, wherein the tungsten layer reduces fluoride diffusion into an underlying layer.

**27.** A method of depositing tungsten on a multilevel substrate, comprising:

a) providing a substrate;

b) biasing the substrate;

c) depositing a first tungsten layer; and

d) altering the film stress level of the multilevel substrate with the first tungsten layer.

28. A method of deposition a tungsten layer on a substrate, comprising:

a) sputtering tungsten from a target;

b) exposing the tungsten to nitrogen; and

c) depositing the tungsten and nitrogen on a substrate to form a tungsten nitride layer.

29. A method as claimed in claim 28, further comprising ionizing tungsten atoms with a plasma.

30. A method as claimed in claim 28 or claim 29, further comprising depositing a conductive layer on the tungsten nitride layer, the conductive layer comprising copper, aluminium, tungsten or combinations thereof.

31. A substrate comprising a barrier layer of sputtered tungsten nitride on a substrate.

32. A substrate as claimed in claim 31, wherein the sputtered tungsten nitride layer has a thickness of at least about 250Å.

33. A substrate as claimed in claim 31 or claim 32, further comprising a layer of copper, aluminium, tungsten or combinations thereof on the tungsten nitride barrier layer.

34. A method of depositing tungsten on a substrate, comprising:

a) sputtering tungsten from a target to form a first tungsten layer; and

b) depositing a second tungsten layer by a chemical vapor deposition (CVD) process on the first tungsten layer.

35. A method as claimed in claim 34, wherein the CVD process is a hydrogen reduction process of tungsten.

36. A substrate processing system comprising:

a) a sputtering chamber having a tungsten target disposed in the chamber connected to a first power supply and a substrate support disposed in the chamber;

b) a coil disposed between the target and the substrate support connected to a second power supply; and

c) a controller that controls a first power output from the first power supply to sputter material from the tungsten target.

37. A system as claimed in claim 36, wherein the controller further controls a second power output from the second power supply to ionize the sputtered material.

38. A system as claimed in claim 37, wherein the controller further controls a third power output from a third power supply that biases the substrate support to provides directional attraction of the ionized sputtered material.

39. A system as claimed in any of claims 36 to 38, further comprising a robot disposed adjacent the chamber that delivers substrates to the chamber.

40. A system as claimed in any of claims 36 to 39, further comprising a chemical vapor deposition chamber disposed in proximity to the sputtering chamber.

*Fig.  1*

*Fig.  2A*

56
54
52

2

47                        46

44

40

## Fig. 2B

58
54
52

2

47                        46

44

40

## Fig. 2C

*Fig. 2*

EP 1 094 504 A2

352

MICROPROCESSOR /
CONTROLLER

350

364

364

364

360

370
368

366
362

364

372
374

365

365

356

356

358

354

Fig. 3

Fig. 3A

Fig. 4

Fig. 5

Fig. 6

Fig. 7

Fig. 8

Fig. 9

Fig. 10

Fig. 11

Fig. 12

Fig. 13

Fig. 14